# EUROPEAN PATENT APPLICATION

(11) **EP 1 170 841 A2**
(43) Date of publication of application: **09.01.2002**
(21) Application number: 01116355.7
(22) Date of filing: 05.07.2001
(51) Int. Cl.: H01S 5/323, H01L 33/00

(54) **Optical semiconductor device, method for manufacturing the same**

(30) Priority: 07.07.2000 JP 2000207462
(71) Applicant: NEC CORPORATION, Tokyo (JP)
(72) Inventor: Sakata, Yasutaka, Minato-ku, Tokyo (JP)
(74) Representative: Glawe, Delfs, Moll

(57) **Abstract**

An optical semiconductor device is constituted from a group III-V compound semiconductor of which a crystal is grown by a selective metal-organic vapor phase epitaxy. At least two kinds of the group V elements are included and the compound semiconductor is formed under a group V element supplying condition different from that of a non-selective metal-organic vapor phase epitaxy so that the compound semiconductor includes the desired proportions of the group V elements.

## Description

### BACKGROUND OF THE INVENTION

### Field of the Invention

The present invention relates to an optical semiconductor device and a method for manufacturing the same, and a technology preferably applied to an optical module and an optical communication apparatus provided with the optical semiconductor device.

### Description of the Related Art

Semiconductor lasers and semiconductor optical modulators are key devices which support optical fiber communications systems, and are strongly required to have a higher performance, more advanced functions, and a lower cost as technology advances to meet the rapidly growing demands for telecommunication.

In trunk communication networks which provide high-speed and long-distance signal transmission, distributed feedback laser diodes (DFB-LD) and external optical modulators play important roles as the source and processor of optical signals. Recently, monolithic integration of these devices has made it possible to reduce the size, power consumption, and cost of the device.

The integrated device, which is called an DFB-LD integrated with electro-absorption type modulator (DFB/MOD), is manufactured by making use of in-plane band gap control technology in the selective metal-organic vapor phase epitaxy (MOVPE) process.

On the other hand, there is increasing pressure to reduce the cost by optical fiber subscribers' lines. Thus, a spot-size converter integrated laser diode (SSC-LD), which operates over a broad range of temperatures and which has a semiconductor laser that performs the functions of a lens, is viewed as the key device for providing a module incorporating the semiconductor laser as the light source without using a temperature regulator and lenses. Manufacture of the SSC-LD also employs in-plane band gap control technology and film thickness control technology based on the selective MOVPE process.

The mechanism and characteristics of growing crystals by the selective MOVPE process, which is widely employed for manufacturing semiconductor optical devices, are described in detail by T. Sakai et al. (Journal of Crystal Growth; Vol. 132, pp. 435-444, 1993) and Y. Sakata et al. (Journal of Crystal Growth; Vol. 208, pp. 130-136, 2000).

As described in these documents, the band gap wavelength and film thickness can be changed in the wafer surface by the selective MOVPE process through a mechanism as described below. There are two reasons for the film thickness (growth rate) to be changed by selective growth.

The first reason is as follows. Since the material of group III elements, which has reached a dielectric mask provided on the surface of the semiconductor substrate in order to carry out selective growth, is not deposited on the dielectric material (crystal growth does not occur), the particles of these elements migrate over the mask surface to reach the growth region. Consequently, as the mask width increases, the amount of the group III element material which migrates increases, thereby increasing the growth rate of the selective growth region. In the case of a compound semiconductor which includes a plurality of group III elements such as InGaAsP, the distance of migration and the probability of being captured in the selective growth region are different among the different group III elements, and therefore the band gap wavelength varies as the proportions of the group III elements (proportions of In and Ga in the case of InGaAsP) in the selective growth region change.

The second reason is as follows. Since the group III element material which has reached the dielectric mask is not deposited on the dielectric material (crystal growth does not occur) as described above, the concentration of the element in the vapor phase on the dielectric mask increases while the particles of the element are consumed in growing the crystal in the selective growth region, thus resulting in decreasing the concentration of the element in the vapor phase. As a result, vapor phase diffusion occurs because the concentration of the element has a graded distribution in the lateral direction parallel to the substrate in the vapor phase, thus leading to a flow of the source materials of the element from the dielectric mask region into the selective growth region.

Since the amount of diffusion increases as the width of the dielectric mask increases, the rate of crystal growth increases with the width of the dielectric mask. Also, in the case of a compound semiconductor which includes a plurality of group III elements such as InGaAsP, the distance of migration in the vapor phase diffusion and the probability of being captured in the selective growth region are different among the different group III elements, and therefore the band gap wavelength varies as the proportions of the group III elements (proportions of In and Ga in the case of InGaAsP) change in the selective growth region.

It was previously believed that only the proportion of a group III element changes in the selectively grown layer with the proportion of a group V element remaining unchanged when the width of the dielectric mask is changed. This is because the selective MOVPE process is carried out under conditions of an oversupply of a group V element where the group V element has a very low adhesion coefficient, which means there is no gradient in the concentration distribution of the group V element between the selective growth region and the dielectric mask forming region, and therefore it has been believed that a flow of the source materials of the group V element from the dielectric mask region into the selective growth region does not occur, and the proportion of the group V element does not change.

Recently, however, by studying the proportions of the group III and the group V elements from the crystal lattice constant of the selective growth region derived from micro X-ray diffraction analysis which allows microscopic evaluation of a selectively grown InGaAsP layer and from the band gap wavelengths determined by microscopic photoluminescence measurements, we have found that not only the proportions of the group III elements but also the proportions of the group V elements change when the width of the dielectric mask changes.

Thus when a compound semiconductor, which includes at least two kinds of group V elements, is manufactured by the selective MOVPE process, not only the proportions of the group III elements but also the proportions of the group V elements change when the width of the dielectric mask changes. But in the prior art, the conditions for crystal growth were determined with consideration given only to the change in the proportions of the group III elements, not to the change in the proportions of the group V elements, leading to such problems as described below.
(1) A crystal having the desired proportions of elements cannot be obtained when a compound semiconductor which includes two or more kinds of group V elements is manufactured by the selective MOVPE process.
(2) The characteristics of a semiconductor optical device constituted mainly from a compound semiconductor which includes at least two kinds of group V elements manufactured by the selective MOVPE process are degraded.

### SUMMARY OF THE INVENTION

The present invention has been made in light of the problems described above, and an object thereof is to provide a means for matching both the band gap wavelength and the lattice constant to the design values by controlling the proportions of the group V elements to desired values when manufacturing a compound semiconductor which includes two or more kinds of group V elements, such as InGaAsP, by the selective MOVPE process. Another object of the present invention is to improve the characteristics of a semiconductor optical device constituted mainly from a compound semiconductor which includes at least two kinds of group V elements, such as InGaAsP, by the selective MOVPE process.

The optical semiconductor device and the method for manufacturing the same according to the present invention aim at providing a means for improving the characteristics of the semiconductor optical device formed by the selective MOVPE process, namely achieving a crystal of high quality grown by the selective MOVPE process by making corrections for the change in the proportions of the group V elements which has been ignored in the prior art.

The present invention provides an optical semiconductor device constituted mainly from a III-V compound semiconductor crystal grown by the selective metal-organic vapor phase epitaxy process which includes at least two kinds of group V elements, and achieves the objects described above by forming the III-V compound semiconductor under the conditions of supplying group V element materials different from those of the non-selective metal-organic vapor phase epitaxy process in order for the compound semiconductor to include the group V elements in the desired proportions.

In the optical semiconductor device of the present invention, the III-V compound semiconductor crystal grown by the selective metal-organic vapor phase epitaxy process preferably has an optical waveguide structure.

According to the present invention, the III-V compound semiconductor crystal grown by the selective metal-organic vapor phase epitaxy process may be used as an active layer of a semiconductor laser.

According to the present invention, the III-V compound semiconductor grown by the selective metal-organic vapor phase epitaxy process is used as a light absorption layer of a semiconductor optical modulator.

According to the present invention, the III-V compound semiconductor grown by the selective metal-organic vapor phase epitaxy process is used as a light absorption layer of a semiconductor laser optical detector.

According to the present invention, the III-V compound semiconductor grown by the selective metal-organic vapor phase epitaxy process is used as a core layer of a semiconductor optical multiplexer/demultiplexer.

According to the present invention, the III-V compound semiconductor grown by the selective metal-organic vapor phase epitaxy process is used as a core layer of a semiconductor optical switch.

The optical semiconductor device of the present invention may be constituted by integrating at least two kinds of the optical semiconductor device comprising the III-V compound semiconductor grown by the selective metal-organic vapor phase epitaxy process as the components thereof.

The method of the present invention for manufacturing the optical semiconductor device comprising the III-V compound semiconductor which includes two or more kinds of group V elements is based on the selective metal-organic vapor phase epitaxy process, and the amounts of the group V element materials supplied are controlled to desired values based on a correction of the conditions of the non-selective metal-organic vapor phase epitaxy process in order to achieve the desired proportions of the group V elements in the selective growth region, thereby solving the problems described above.

The method of the present invention for manufacturing the optical semiconductor device comprising the III-V compound semiconductor which includes two or more kinds of group III elements and two or more kinds of group V elements is based on the selective metal-organic vapor phase epitaxy process, wherein the amounts of the group III element materials and the group V element materials supplied are corrected according to the conditions of the non-selective metal-organic vapor phase epitaxy process in order to control the band gap energy and the proportions of the group V elements in the selective growth region to desired values, thereby solving the problems described above.

According to the present invention, the selective metal-organic vapor phase epitaxy process may be a narrow-width selective metal-organic vapor phase epitaxy process which is capable of directly forming a semiconductor optical waveguide.

According to the present invention, the amount of correction from the conditions of the selective metal-organic vapor phase epitaxy process can be determined so that the peak intensity of the photoluminescence spectrum that determines the band gap wavelength becomes a maximum, while changing the amounts of the group III element materials and the group V element materials being supplied at the same time under conditions such that the band gap wavelength remains constant.

According to the present invention, the amount of correction from the conditions of the selective metal-organic vapor phase epitaxy process can be determined so that the half-width of the photoluminescence spectrum that determines the band gap wavelength becomes a minimum, while changing the amounts of the group III element materials and the group V element materials being supplied at the same time under conditions such that the band gap wavelength remains constant.

According to the present invention, the III-V compound semiconductor may include at least one element selected from among indium, gallium, aluminum, and thallium as the group III element and at least two elements selected from among phosphorus, arsenic, nitrogen, and antimony as the group V elements.

According to the present invention, the III-V compound semiconductor may specifically be InGaAsP.

According to the present invention, the optical module comprises the optical semiconductor device described above or an optical semiconductor device manufactured by the manufacturing method of the present invention, a means for extracting the optical output from the optical semiconductor device, a mechanism for sending the optical output from the optical semiconductor device to the extracting means, and an electric interface for driving the optical semiconductor device, thereby achieving the objects described above.

According to the present invention, the optical module may comprise the optical semiconductor device described above or an optical semiconductor device manufactured by the manufacturing method of the present invention, a means for extracting the optical output light to the optical semiconductor device from the outside, a mechanism for sending the optical output to the optical semiconductor device from the extracting means, and an electric interface for driving the optical semiconductor device.

The present invention provides an optical communication apparatus comprising the optical semiconductor device described above or an optical semiconductor device manufactured by the manufacturing method of the present invention, or the optical module and a receiving apparatus for receiving the optical output from an optical transmitter, thereby achieving the objects described above.

According to the present invention, the optical communication apparatus may comprise an optical receiver which has the optical semiconductor device described above or an optical semiconductor device manufactured by the manufacturing method of the present invention, or the optical module installed therein and a transmitter for transmitting the optical input to the optical receiver.

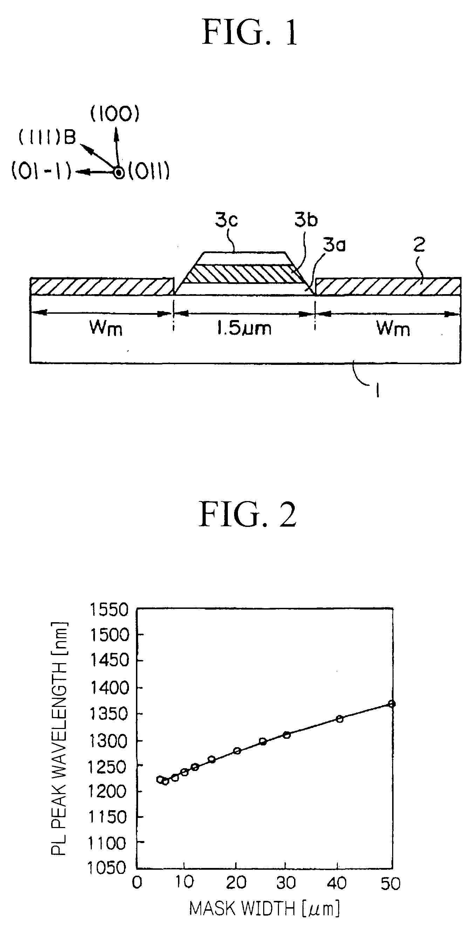

FIG. 1 is a schematic sectional view showing the optical semiconductor device having the composition of InP/InGaAsP/InP formed by the selective MOVPE growing process, wherein reference symbol 1 denotes a (100) InP substrate and 2 denotes an SiO₂ stripe mask.

According to the present invention, as shown in FIG. 1, the InP/InGaAsP/InP structure is selectively grown by the selective MOVPE growing process wherein an InP layer 3a, an InGaAsP layer 3b, and an InP layer 3c are stacked by using the stripe mask 2 constituted from a pair of dielectric films (SiO₂) formed on the (100) InP substrate 1 at a 1.5 µm interval in the [011] direction. This results in the growth of a crystal in a trapezoidal shape defined by a side surface lying in the (111) B plane and the top surface lying in the (100) plane.

When the width Wm of the stripe mask 2 is increased, it is known that the growth rate (film thickness) increases due to the inflow of the material from above the stripe mask 2, and the proportion of In increases in the InGaAsP layer 3b. When these phenomena are utilized, it becomes possible to form a layer structure having different band gap wavelengths in the same substrate surface simply by changing the width Wm of the stripe mask 2.

It was previously believed that only the proportion of the group III element changes with the proportion of the group V element remaining unchanged when the width Wm of the stripe mask 2 is changed. This is for the following reason.

Since the selective MOVPE growing process is carried out under conditions of an oversupply of a group V element material where the group V element material has a very low adhesion coefficient which means there is no gradient in the concentration distribution of the group V element between the selective growth region and the dielectric mask forming region, it has been believed that the flow of the source materials of the group V element from the dielectric mask region into the selective growth region does not occur, and therefore the proportion of the group V element does not change.

However, it has been found that not only the proportion of the group III element but also the proportion of the group V element changes when the width Wm of the stripe mask 2 changes, by studying the dependency of the proportions of the group III and group V elements on the width Wm of the dielectric stripe mask 2, from the band gap wavelengths determined by microscopic photoluminescence (microscopic PL) measurements which allow microscopic evaluation of the selectively grown InGaAsP layer 3b, and from the crystal lattice constant of the selective growth region derived from micro X-ray diffraction analysis. The experiment and the results thereof will be described below.

The microscopic PL method was carried out by using an argon ion laser oscillating at a wavelength of 514.5 nm as the excitation light source with the beam regulated to have a diameter of 1 µm.

The micro X-ray diffraction analysis was carried out by using a micro X-ray beam regulated so as to have a diameter of 5 µm, which was generated from synchrotron radiation light (SR light) of 15 keV in energy and 0.0827 nm in the X-ray wavelength.

FIG. 2 shows the relationship between the band gap wavelength of the selectively grown InGaAsP layer 3b measured by the microscopic photoluminescence (PL) method and the width of the SiO₂ mask. In FIG. 2, the PL peak wavelength which corresponds to the band gap wavelength is plotted along the ordinate and the SiO₂ mask width is plotted along the abscissa.

From the results, it can be seen that the PL peak wavelength (band gap wavelength) becomes longer as the mask width increases. This has previously been interpreted as the result of compressive strain being introduced by the increase in the proportion of In which is a group III element.

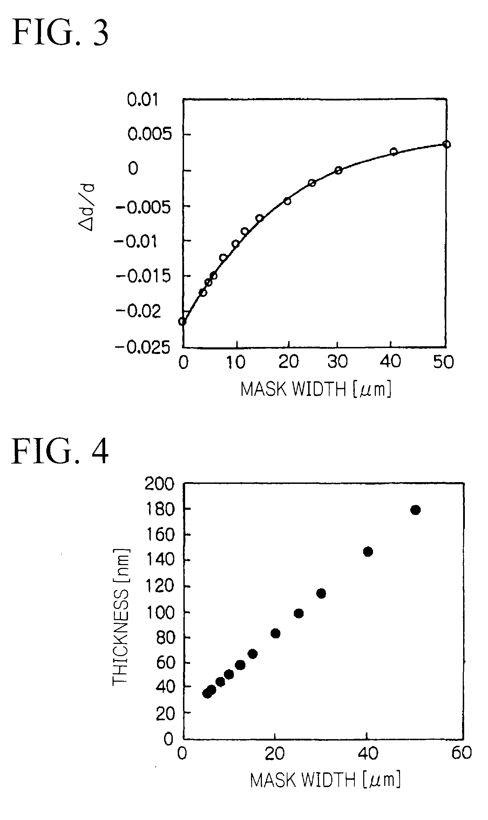

The mask width dependency of the lattice strain (Δ d/d) of the selectively grown InGaAsP layer 3b with respect to the InP substrate determined by the micro X-ray diffraction analysis is shown in FIG. 3.

In FIG. 3, the ratio Δ d/d represents the lattice strain, and the graph shows that the lattice constant increase, shifting toward the compressive strain side as the mask width increases.

FIG. 4 shows the relationship of the mask width to the film thickness of the selectively grown InGaAsP layer 3b measured with a scanning electron microscope.

The proportions of the constituent elements of InGaAsP can be uniquely determined when provided with the information of the band gap wavelength and the lattice constant, plus the film thickness for the case when a quantum effect is added to the band gap wavelength.

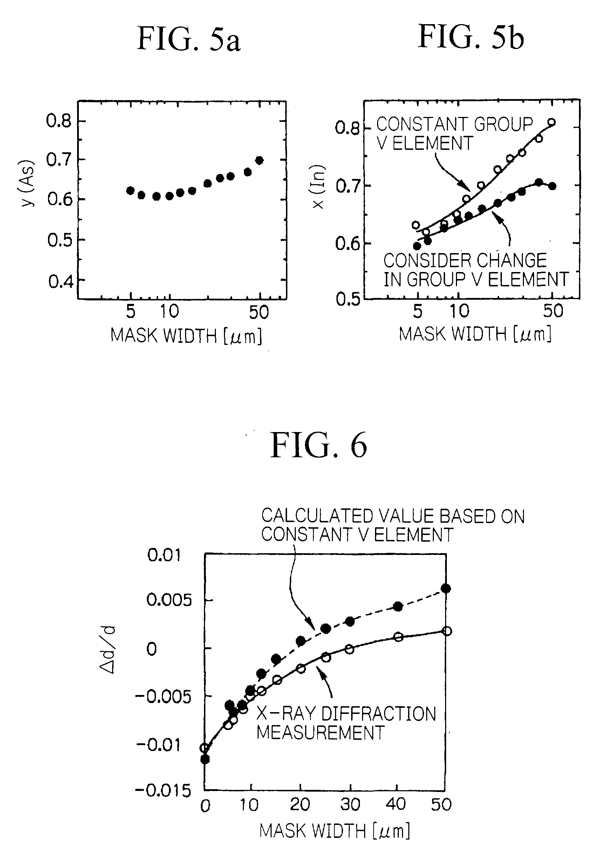

Based on the results of the experiments shown in FIGS. 2, 3 and 4, the crystal composition of the selectively grown InGaAsP layer 3b was calculated. FIG. 5 shows the mask width dependency of the proportion y of group V element As and the proportion x of group III element In for the case when the composition of InGaAsP is represented as InₓGa₁₋ₓAs_{y}P_{1-y} (0 ≦ x ≦ 1, 0 ≦ y ≦ 1).

It is found from the results that the proportion y of the group V element As does not remain constant as had been thought previously, but clearly changes in accordance with the mask width, with the change amounting to 15% or larger in a region of larger mask width (FIG. 5a). On the other hand, it is found that the proportion x of the group III element In increases with the mask width, although the change is smaller than the value (marked with white circles) which is determined under the conventional assumption that the proportion of the group V element does not change, as indicated by the points marked by black circles in FIG. 5b.

Since it has been believed that the proportion of the group V element does not change in InGaAsP grown by the selective MOVPE process, and X-ray diffraction measurements capable of determining the lattice constant in a microscopic region have not been established, the crystal growing conditions have been determined by estimating the lattice strain from only the PL peak wavelength and the film thickness shown in FIG. 2 and FIG. 4, thereby correcting the flow rate of the group III material based on the estimation. In this case, it is supposed that the estimated value of the lattice strain is different from the actual value of the lattice strain.

The values of the lattice strain (Δ d/d) calculated from the measurement data shown in FIG. 2 and FIG. 4 under the assumption of a constant proportion of the group V element are compared with the measured values of the lattice strain (Δ d/d) derived from the micro X-ray diffraction analysis shown in FIG. 3, as shown in FIG. 6.

Although no significant difference is observed between the values obtained by the different methods in a region of the mask width within 10 µm, a significant difference arises between the value calculated based on the conventional assumption and the measured value in a region of larger mask width where the proportion of the group V element changes substantially, thus leading to an overestimation on the compression strain side.

Consequently, when the crystal growth conditions are set so as to achieve lattice matching of the InGaAsP 3b layer grown by the selective MOVPE process to the InP substrate by employing the amount of lattice strain calculated based on the conventional assumption, a tensile-strained crystal would result. For example, with a mask width of 30 µ m, the selectively grown InGaAsP layer shown in FIG. 6 does not include lattice strain and is lattice-matched with the InP substrate (plotted with white circles in FIG. 6), although the value calculated based on the conventional assumption (plotted with black circles in FIG. 6) gives false recognition of the compressive strain of Δ d/d = +0.003 (+0.3%). Consequently, feedback of the result of this calculation into the selective MOVPE process condition results in the introduction of strain amounting to Δ d/d =-0.003 (-0.3%). This also applies to the case of a strained quantum well structure where lattice strain is intentionally introduced, thus giving rise to a problem such that the desired amount of lattice strain cannot be introduced.

Therefore, it can be seen that it is important to set the growing conditions by taking into consideration the fact that the proportion of the group V element as well as the group III element changes with the mask width when making a compound semiconductor, such as InGaAsP, which includes two or more kinds of group V elements by the selective MOVPE process.

The proportions of the constituents In, Ga, As, and P in InGaAsP can be uniquely determined from the two parameters of the band gap wavelength and the lattice constant, or three parameters including the film thickness added to the above, for the case when a quantum effect is added to the band gap wavelength. However, the X-ray diffraction analysis technique that uses a micro X-ray beam on a microscopic scale has not yet advanced to a stage such that can be easily used for determining the lattice constant in the selective growth region in the routine work.

Next, a convenient method will be described below for setting the crystal growth conditions while taking into consideration the fact that the proportion of the group V element as well as the proportion of the group III element changes with the mask width for the case of growing a compound semiconductor, such as InGaAsP, by the selective MOVPE process.

This method relies only on the microscopic PL measurement for setting the conditions of lattice matching in some area of an InP substrate with a desired mask width when forming InGaAsP by narrow-width selective growth.

Assume the thickness of the InGaAsP layer which is to be grown by the selective MOVPE process to be several hundreds of nanometers or greater. In this case, since the existence of a lattice mismatch exceeding a certain level causes dislocation in the crystal, non-radiative centers increase and the band gap energy fluctuates due to relaxation of the lattice strain. Thus the PL measurement provides a decreasing PL light emission intensity and an increasing PL spectrum width.

Accordingly, it becomes possible to set the lattice matching conditions to within a certain range by deriving lattice matching conditions that maximize the PL intensity or minimize the PL spectrum width. The film thickness at which dislocation begins to appear, which is called the critical thickness, is inversely proportional to a amount of strain, while the strain that corresponds to a critical thickness of 100 nm is 0.13%, and is about 0.07% for a critical thickness of 200 nm for the case of an InGaAsP crystal. Therefore, the lattice matching conditions can be determined with an accuracy of residual strain to within 0.1% so as to maximize the PL intensity or minimize the PL spectrum width in the selective MOVPE growth process to a film thickness of about 200 nm with a desired mask width.

Next, an experiment conducted by the inventors will be described below with reference to the accompanying drawings.

After starting with the initial conditions of selective growth being set to lattice matching conditions for non-selective (MOVPE) growth, both the As/P ratio and In/Ga ratio are changed simultaneously under the conditions which maintain a constant band gap wavelength (PL peak wavelength). Microscopic PL measurement is conducted while changing the amount of the variation in the ratios, in order to determine values of the As/P ratio and In/Ga ratio such that the combination thereof maximizes the PL light emission intensity or minimizes the PL spectrum width.

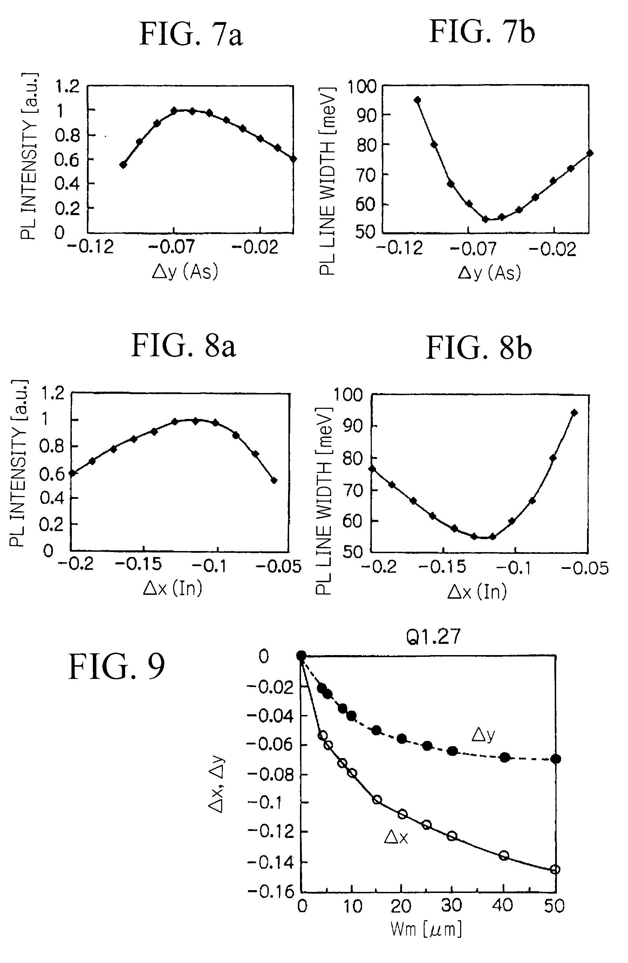

FIG. 7 shows an example of the lattice matching conditions for InGaAsP having a band gap wavelength of 1.27 µm (hereinafter denoted as Q1.27) with a mask width Wm of 25 µm.

In FIG. 7, the PL intensity is shown in FIG. 7a, and the PL line width is shown in FIG. 7b, both measured on an InGaAsP crystal grown by the selective MOVPE process for various combinations of the values of the As/P ratio and In/Ga ratio such that the band gap wavelength (PL peak wavelength) becomes 1.27 ± 0.005 µm with a mask pattern having a width (Wm) of 25 µm.

The variation in the proportion of As (Δy) is plotted along the abscissa in both FIG. 7a and FIG. 7b. The value of Δy is the variation from that of the lattice matching conditions for non-selective MOVPE growth of Q1.27 having an InGaAsP composition of InₓGa₁₋ₓAs_{y}P_{1-y} (0 ≦ x ≦ 1,0 ≦ y ≦ 1).

As is apparent from FIG. 7, the PL intensity reaches a peak and the PL half-width value reaches a minimum value at around Δy = -0.06. As described above, the condition required for lattice matching of Q1.27 at Wm = 25 µm is Δ y = -0.06. This value agrees with the variation in the proportion of As derived from the results of X-ray diffraction analysis conducted by using the micro X-ray beam and the microscopic PL measurement shown in FIG. 5 (y = 0.606 at Wm = 0, though not shown in FIG. 5).

While FIG. 7 shows the PL intensity and the PL half-width value as functions of the variation in the proportion As/P of the group V composition, the same data can be represented as functions of the variation in the proportion In/Ga of the group III composition, as shown in FIG. 8.

In FIG. 8, the PL intensity is plotted in FIG. 8a, and the PL half-width value is plotted in FIG. 8b as a function of Δx (deviation of the In proportion from the lattice matching condition for a non-selective MOVPE) which is plotted along the abscissa.

From the graphs, it can be determined that the condition for lattice matching of Q1.27 at Wm = 25 µm is Δx=-0.116 (Δy = -0.06, at this time).

FIG. 9 shows the values of Δx and Δy determined so as to achieve lattice matching of Q1.27 with mask widths of Wm = 0 to 50 µm by the method shown in FIG. 7 and FIG. 8.

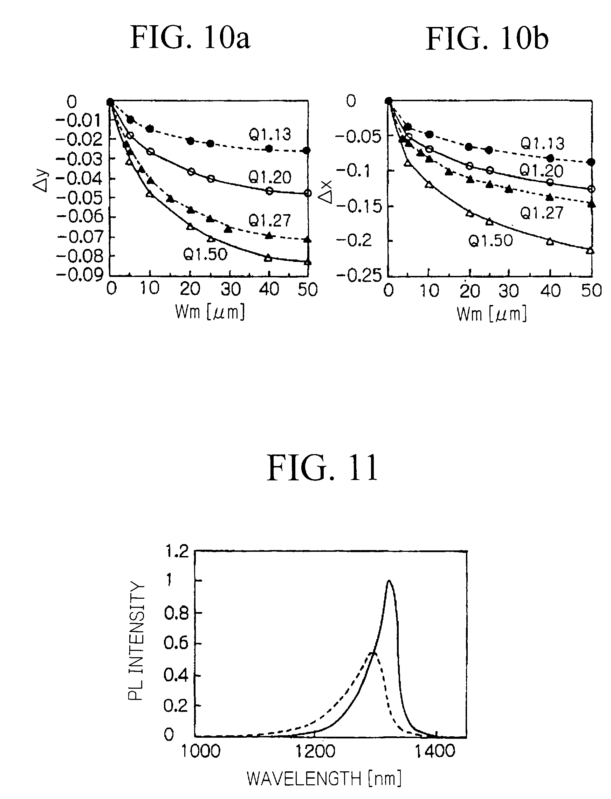

The values of Δx and Δy which achieve lattice matching of Q1.27 to InP with a given value of Wm can be determined by using the results shown in FIG. 9. FIG. 10 shows the values of Δx and Δy determined to achieve lattice matching with mask widths of Wm = 0 to 50 µm for InGaAsP having band gap wavelengths of 1.13 µm, 1.20 µm, and 1.50 µm (hereinafter referred to as Q1.13, Q1.20, and Q1.50).

Then a strained InGaAsP multi-quantum well (MQW) having a 1.3 µm band had made by using the selective MOVPE conditions for InGaAsP which had been derived; the PL characteristic evaluation results are described below. A mask width of Wm = 25 µm was used for this selective growth.

The quantum well structure was formed using strained InGaAsP with 1.0% of compressive strain introduced by shifting the proportion of the group III element from that of the lattice matching condition of Q1.27 as the well layer; and lattice-matched Q1.13 for the barrier layer. The thickness of the well layer and that of the barrier layer were set to 5 nm and 10 nm, respectively, and the number of repetitions of the MQW structure was set to 8 cycles. Light confinement (SCH) layers comprising lattice-matched Q1.13 having a thickness of 60 nm were provided above and below the MQW structure.

FIG. 11 shows the PL spectra of the strained MQW structure which was grown by the selective MOVPE process. The solid line indicates the spectrum of Q1.27 and Q1.13 grown under the conditions of Δx and Δy shown in FIG. 10, and the dashed line indicates the spectrum for the case of growing under the conventional conditions wherein the variation in the proportion of the group V element is not taken into consideration. While the spectrum of the PL intensity represented by the solid line, which accounts for the variation in the proportion of the group V element, has a very small half-width of 25 meV, the spectrum of the conventional conditions represented by the dashed line has a large half-width of 44 meV with the PL peak intensity decreasing by 40% or more. This is because the well layer does not include a desired amount of strain introduced therein when the variation in the proportion of the group V element is not taken into consideration, and the barrier layer and the SCH layer are not lattice-matched to the InP substrate, and therefore crystal defects are included.

### BRIEF DESCRIPTION OF THE DRAWINGS

Some of the features and advantages of the invention have been described, and others will become apparent from the detailed description that follows and from the accompanying drawings, in which:
FIG. 1 is a sectional view of a growing crystal for explaining the operation of the optical semiconductor device according to the present invention;
FIG. 2 is a characteristic curve of crystal growth for explaining the operation of the optical semiconductor device according to the present invention;
FIG. 3 is a characteristic curve of crystal growth for explaining of the operation of the optical semiconductor device according to the present invention;
FIG. 4 is a characteristic curve of crystal growth for explaining of the operation of the optical semiconductor device according to the present invention;
FIGS. 5a and 5b are characteristic curves of crystal growth for explaining of the operation of the optical semiconductor device according to the present invention;
FIG. 6 is a characteristic curve of crystal growth for explaining the operation of the optical semiconductor device according to the present invention;
FIGS. 7a and 7b are characteristic curves of crystal growth for explaining the operation of the optical semiconductor device according to the present invention;
FIGS. 8a and 8b are characteristic curves of crystal growth for explaining the operation of the optical semiconductor device according to the present invention;
FIG. 9 is a characteristic curve of crystal growth for explaining the operation of the optical semiconductor device according to the present invention;
FIGS. 10a and 10b are characteristic curves of crystal growth for explaining the operation of the optical semiconductor device according to the present invention;
FIG. 11 is a characteristic curve of crystal growth for explaining the operation of the optical semiconductor device according to the present invention;

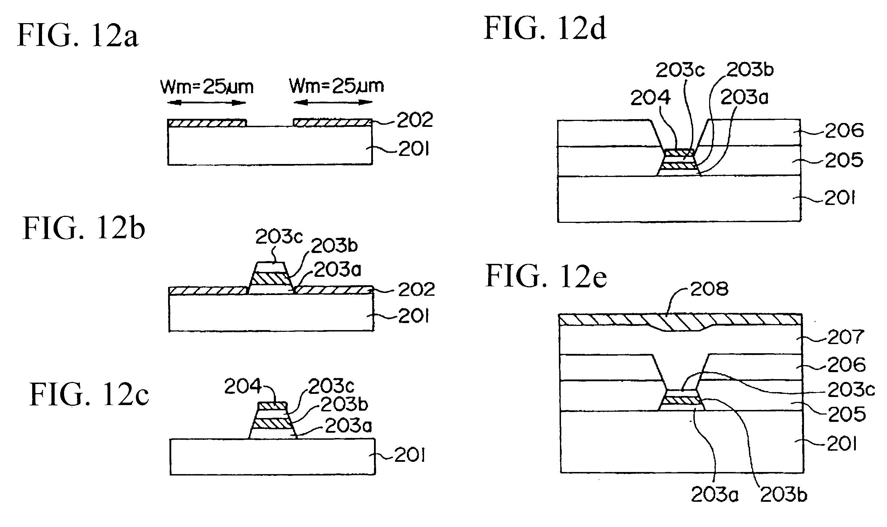

FIGS. 12a through 12e are sectional views of the process showing the first embodiment of the method for manufacturing the optical semiconductor device according to the present invention;

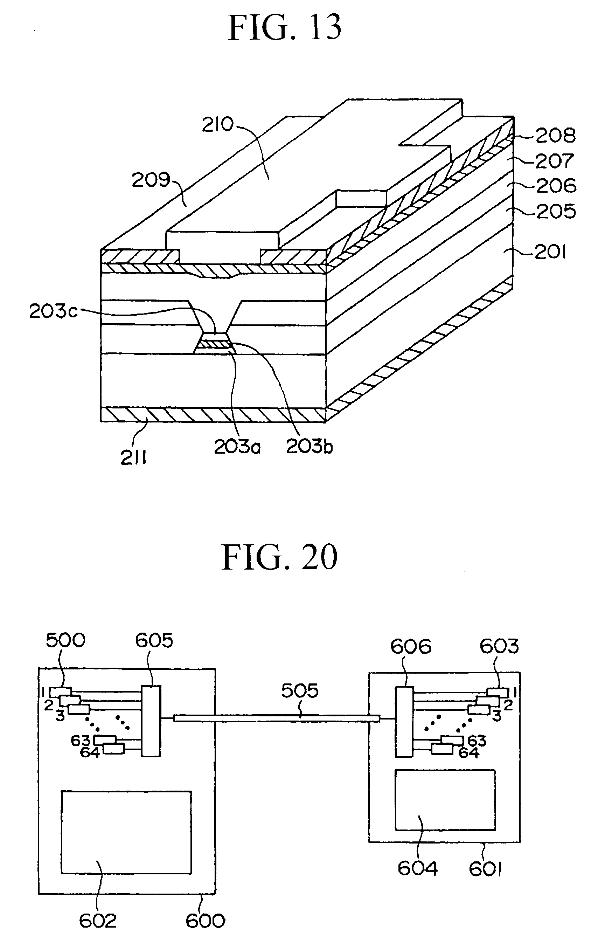

FIG. 13 is a schematic sectional view showing the first embodiment of the optical semiconductor device according to the present invention;

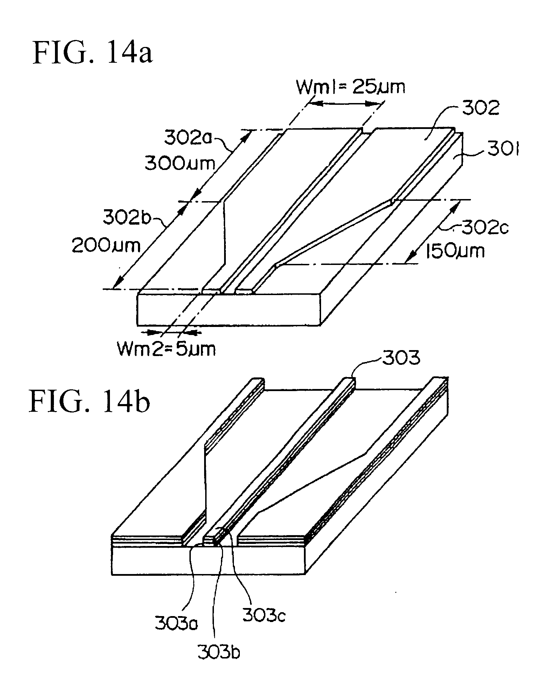

FIGS. 14a and 14b are perspective views of the process showing the second embodiment of the method for manufacturing the optical semiconductor device according to the present invention;

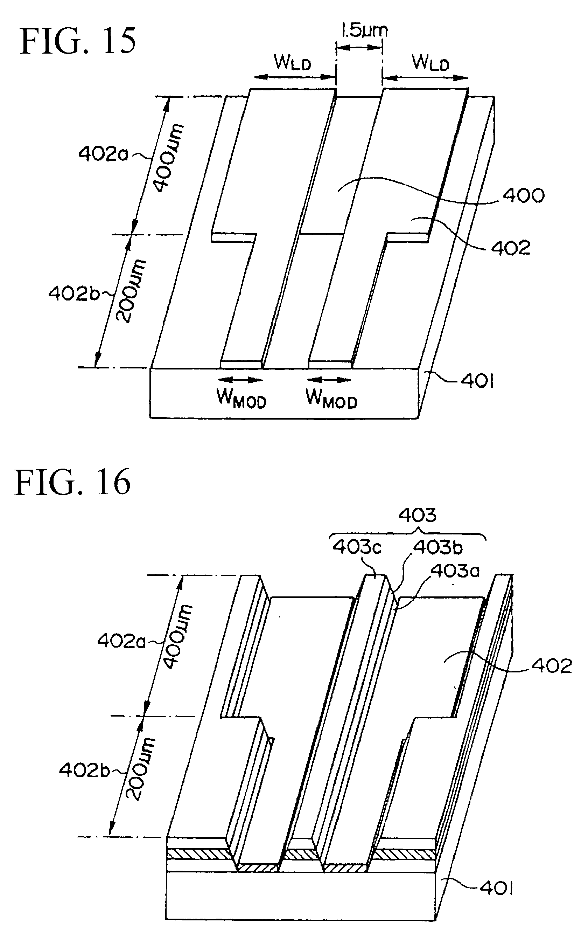

FIG. 15 is a perspective view of the process showing the third embodiment of the method for manufacturing the optical semiconductor device according to the present invention;
FIG. 16 is a perspective view of the process showing the third embodiment of the method for manufacturing the optical semiconductor device according to the present invention;

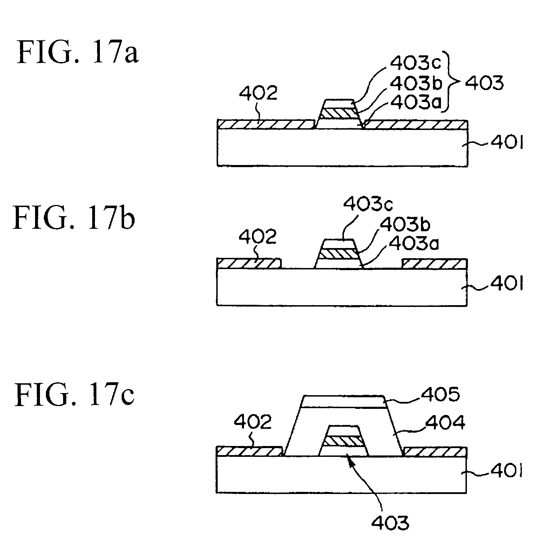

FIGS. 17a through 17c are sectional views of the process showing the third embodiment of the method for manufacturing the optical semiconductor device according to the present invention;

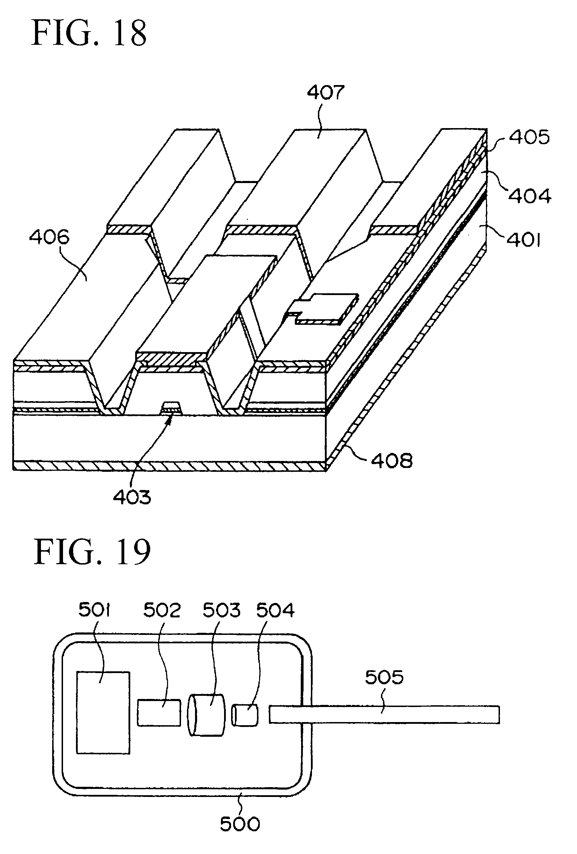

FIG. 18 is a schematic perspective view showing the third embodiment of the optical semiconductor device according to the present invention;
FIG. 19 is a schematic view showing the fourth embodiment of the optical transmission module according to the present invention; and
FIG. 20 is a schematic view showing the fifth embodiment of the optical semiconductor system according to the present invention.

### DETAILED DESCRIPTION OF THE INVENTION

Next, the first embodiment of an optical semiconductor device and a method for manufacturing the same according to the present invention, and an optical module and an optical communication apparatus which incorporate the optical semiconductor device will be described below with reference to the accompanying drawings.

FIG. 12 shows a process of manufacturing a semiconductor laser (optical semiconductor device) of this embodiment. FIG. 13 is a schematic perspective view of the semiconductor laser (optical semiconductor device) of this embodiment.

In FIG. 12 and FIG. 13, reference numeral 201 denotes a (100) InP substrate.

The semiconductor laser of this embodiment has a strained InGaAsP MQW structure 203 formed in a stripe pattern in the [011] direction on the (100) InP substrate 201 which has an n-type electrode 211 on the under side thereof as shown in FIG. 13.

Such a structure is formed by the selective MOVPE process as an InGaAsP-MQW structure layer 203b is sandwiched by an n-InP layer 203a and a p-InP layer 203c.

p-InP layers 205 are formed at a position higher than the top surface of the p-InP layer 203c on both sides of the MQW structure 203, with an n-InP layer 206 being provided on the p-InP layer 205.

The entire surfaces of the p-InP layer 203c and the n-InP layer 206 are covered by a p-InP cladding layer 207. The bottom of the p-InP cladding layer 207 is embedded in a trough formed by the p-InP layer 205 and the n-InP layer 206 in which the strained MQW structure 203 is located, and is connected to the n-InP layer 206. The p-InP cladding layer 207 is covered by a p+-InGaAs layer 208 over the entire surface thereof, while a p-type electrode 210 formed in a pattern corresponding to the strained MQW structure 203 is provided on the p+-InGaAs layer 208. An SiO₂ layer 209 covers the surface except for the p-type electrode 210 on the p⁺-InGaAs layer 208.

According to the method for manufacturing the semiconductor laser of this embodiment, a pair of SiO₂ stripe masks 202 are patterned at a 1.5 µm interval in the [011] direction on the (100) n-InP substrate 201 as shown in FIG. 12. The mask width (Wm) of the SiO₂ stripe masks 202 is set to 25 µm (FIG. 12a).

The strained InGaAsP MQW structure 203 is formed on the patterned substrate 201 by the selective MOVPE process. The growth temperature is set to 625°C, and the growth pressure is set to 1000 hPa.

The structure formed by the selective MOVPE process comprises the n-InP layer 203a, the strained InGaAsP-MQW structure layer 203b, and the p-InP layer 203c as shown in FIG. 12(b). The carrier concentration is set to n = 1 × 10¹⁸ cm⁻³ and the thickness is set to 0.15 µm for the n-InP layer 203a, and p = 7 × 10¹⁷ cm⁻³ and a thickness of 0.10 µm for the p-InP layer 203b.

The strained MQW structure layer 203b has an SCH layer added thereto such that it is formed by stacking a set of an InGaAsP layer (5 nm thick), with 1.0% of compressive strain introduced therein by shifting the proportion of the group III element from that of the lattice matching condition of Q1.27 as the well layer, and a lattice-matched Q1.13 layer (10 nm thick) as the barrier layer in eight cycles, with a Q1.13 layer (60 nm thick) being lattice-matched to the top and bottom of the repeated structure described above.

As mentioned previously, the process conditions are set by taking into account the variations in the proportions of both the group V and the group III elements with a mask width of Wm = 25 µm. That is, with the variations in the proportions of As and In from those of the lattice matching condition for the total MOVPE growth process being denoted as Δx and Δy, respectively, the variations are set as Δy = -0.022 and Δx = -0.070 for the Q1.13 barrier layer and the SCH layer, and Δy = -0.06 and Δx = -0.116 + 0.1254 = +0.0094 for the strained Q1.27 well layer.

An additional explanation will be given for Δx. A value of Δx = -0.116 is required for lattice matching with a mask width of Wm = 25 µm. Since an additional deviation of Δx = +0.1254 is required by the modification of the proportion of the group III element in order to introduce a compressive strain of +1.0%, the total variation becomes Δx = +0.0094. Through PL spectrum evaluation by the microscopic PL method of the selectively grown structure formed as described above, the PL peak wavelength is 1.31 µm and the PL spectrum half-width is as small as 25 meV.

Then a SiO₂ mask 204 is formed only on the top surface of the selectively grown mesa 203 as shown in FIG. 12(c). This process is carried out similar to that described in detail by Y. Sakata et al. in the IEEE Journal of Quantum Electronics, Vol. 35, pp. 368 - 376, 1999.

With the SiO₂ mask 204 used as a growth blocking mask, a current restricting structure is formed by embedded selective growth of the selective MOVPE process that comprises the p-InP layer 205 (p = 1 × 10¹⁸ cm⁻³ and thickness of 0.7 µm) and the n-InP layer 206 (n = 1 × 10¹⁸ cm⁻³ and thickness of 0.7 µm) as shown in FIG. 12(d).

Then after removing the SiO₂ mask 204, the p-InP cladding layer 207 (p = 1 × 10¹⁸ cm⁻³ and thickness of 1.5 µm) and the p-InGaAs layer 208 (p = 1 × 10¹⁹ cm⁻³ and thickness of 0.3 µm) are grown by the selective MOVPE process as shown in FIG. 12(e).

On the wafer prepared as described above, the semiconductor laser structure as shown in FIG. 13 is formed through a process of forming electrodes.

The characteristics of the laser were evaluated by applying a highly specular coating having a high reflectance of 95% on the rear end of a resonator made to a length of 300 µm.

The laser showed an oscillation threshold current of 3.5 mA, a slope efficiency of 0.62 W/A, and an oscillation wavelength of 1.315 nm at room temperature of 25°C. At a temperature of 85°C, a low oscillation threshold current of 7.9 mA and a high slope efficiency of 0.48 W/A were confirmed. Then an experiment of transmission at 622 Mb/s was conducted with this device; good eye aperture was verified, and the capability of transmission at 622 Mb/s was confirmed over a temperature range from -40 to +85°C.

The semiconductor laser of this embodiment has the effect of improving the characteristics of the semiconductor optical device formed by the selective MOVPE growth process.

Next, the second embodiment of an optical semiconductor device and a method for manufacturing the same according to the present invention, and an optical module and an optical communication apparatus which incorporate the optical semiconductor device will be described below, with reference to the accompanying drawings.

FIGS. 14(a) and (b) show a process of manufacturing a semiconductor laser (optical semiconductor device) of this embodiment.

This embodiment is adapted to a 1.3 µm band semiconductor laser with a spot size converter integrated therein.

The device of this embodiment has a spot size converter (SCC), which enlarges the beam spot at the laser beam emitting end, integrated therein, with the beam spread angle being as small as 1/2 to 1/3 of those of conventional lasers, making it possible to efficiency couple with an optical fiber without using a lens.

The semiconductor laser of this embodiment comprises a strained InGaAsP MQW structure 303 formed in the [011] direction on a (100) InP substrate 301 as shown in FIG. 14(b) similar to the first embodiment shown in FIG. 13.

The strained MQW structure 303 is formed so as to have a laser region 302a having a width of Wm = 25 µm and a laser region length of 300 µm, followed by an SSC region 302b which is narrowed through a transition region 302c of 150 µm so that Wm decreases from 25 µm to 5 µm, with the last 50 µm portion being formed in a portion other than the mask pattern where Wm is constant at 5 µm.

A constitution of this embodiment other than the above has a structure corresponding to the p-InP layer 205, the n-InP layer 206, the p-InP cladding layer 207, the p⁺-InGaAs layer 208, the p-type electrode 210, and the SiO₂ layer 209 shown in the first embodiment, but is not shown in the drawing.

The semiconductor laser of this embodiment is made by patterning a pair of SiO₂ masks 302 as shown in FIG. 14(a) at a 1.5 µm interval in the [011] direction on the (100) InP substrate 301. The laser region 302a which has a mask width Wm = 25 µm and a laser region length of 300 µm is followed by the SSC region 302b which is narrowed through the transition region 302c of 150 µm so that Wm decreases from 25 µm to 5 µm, with the last 50 µm portion being formed in the mask pattern where Wm remains constant at 5 µm.

The n-InP/strained MQW/p-InP structure 303 is formed on the substrate 301 which was patterned as described above by the selective MOVPE process on the substrate 303 which was patterned as described above, similar to the first embodiment. The growing conditions are also the same as those of the first embodiment.

The laser region 302a reproduced the PL characteristic shown by the solid line in FIG. 11. The PL peak wavelength decreased as the mask width Wm decreased in the SSC region, and decreased to as small as 1.10 µm in the region of Wm = 5 µm. Using this selectively grown structure, an SSC integrated semiconductor laser was made by the same process as that of the first embodiment shown in FIG. 12 and FIG. 13.

The characteristics of the laser were evaluated by applying a high-reflection coating having a reflectance of 95% to the rear end face on the laser side, with the laser made to a total length of 500 µm, or 300 µm of the laser region plus 200 µm of the SSC region.

The laser showed an oscillation wavelength of 1315 nm, an oscillation threshold current of 5.5 mA, and a slope efficiency of 0.55 W/A at room temperature of 25°C. At a temperature of 85°C, the oscillation wavelength was 1.336 nm, the oscillation threshold current was 12.5 mA, and the slope efficiency was 0.45 W/A. Measurement of the far field pattern (FFP) showed a beam spread angle of 27° × 30° at the rear end face and a spread angle of 10.5° × 11.0° at the front end face. Then the characteristic of coupling with a flat-end single-mode fiber (1.3 µm, zero dispersion) with an anti-reflection coating applied to the end face thereof was evaluated. A maximum coupling efficiency of -2.2 dB was obtained when the laser was brought to a distance of 10 µm from the fiber.

The semiconductor laser of this embodiment has the effect of improving the characteristics of the semiconductor optical device formed by the selective MOVPE growth process.

Next, the third embodiment of an optical semiconductor device and a method for manufacturing the same according to the present invention, and an optical module and an optical communication apparatus which incorporate the optical semiconductor device will be described below, with reference to the accompanying drawings.

FIG. 15, FIG. 16, and FIG. 17 show a process of manufacturing a semiconductor laser (optical semiconductor device) of this embodiment. FIG. 18 is a schematic perspective view of the semiconductor laser (optical semiconductor device) of this embodiment.

This embodiment is adapted to an electro-absorption (EA) type modulator-integrated distributed feedback (DFB) semiconductor laser.

The semiconductor laser of this embodiment comprises a strained InGaAsP MQW structure 403 formed in the [011] direction on the (100) InP substrate 301 as shown in FIG. 16 similar to the first embodiment shown in FIG. 13 and the second embodiment shown in FIG. 14.

The strained MQW structure 403 is formed so as to have a DFB laser region 402a, in which a diffraction grating 400 is formed, and has a width of WLD = 9 µm and a DFB laser region length of 400 µm, followed by a region 402b, which serves as an EA modulator having a width of WMOD = 5 µm, being formed in portions other than the mask pattern.

The strained MQW structure 403 is covered, on the central portion thereof having a width of 1.5 µm, by a p-InP cladding layer 404 which is wide enough to extend beyond the central portion. The p-InP cladding layer 404 is formed on the strained MQW structure 403 also outside the mask pattern. A p⁺-InGaAs cap layer 405 is formed on the p-InP cladding layer 404.

A portion, measuring 30 µm, of the p⁺-InGaAs cap layer 405 is removed between the DFB laser region 402a and the EA modulator region 402b, and a p-type electrode 407 is formed via an SiO₂ film 406 as an inter-layer film as shown in FIG. 18. An n-type electrode 408 is formed over the entire surface of the back of the n-InP substrate 401.

According to the method for manufacturing the semiconductor laser of this embodiment, first, the diffraction grating 400 is partially formed on the (100) InP substrate 401 by electron beam exposure and wet etching as shown in FIG. 15.

Then, the pair of SiO₂ masks 402 are formed at a 1.5 µm interval in the [011] direction.

The region where the diffraction grating 400 is formed is the region comprising the DFB laser, wherein the mask width is set to WLD = 9 µm (region length of 400 µm) and the subsequent region which comprises the EA modulator is made to have a mask width of WMOD = 5 µm.

By using the SiO₂ stripe masks 402, a structure is formed by the selective MOVPE process such that it comprises the n-InGaAsP guide layer 403a Q1.20 (thickness 100 nm , n = 1 × 10¹⁸ cm⁻³), the strained MQW layer 403b (a stack of 8 sets of well layer InGaAsP (+0.50% strain, 7 nm thick), a barrier layer Q1.20 (6 nm thick)), and the p-InP layer 403c (150 nm thick, p = 1 × 10¹⁷ cm⁻³) as shown in FIG. 16.

The thickness and strain are the values in the region which comprises the EA modulator of WMOD = 5 µm. The strained InGaAsP well layer has a proportion of a group III element which has been changed from that of the lattice matching condition of Q1.50 so that a compressive strain of +0.50% would be introduced. The selective growing conditions for Q1.20 and the strained Q1.50 will be described in detail below.

The process conditions are set using the values of Δx and Δy shown in FIG. 10 since the proportions of both groups V and III change in the selective MOVPE growth region. Specifically, the variations are set as Δy = -0.01733 and Δx =-0.05172 for Q1.20, and Δy = -0.0303 and Δx = -0.0879 + 0.0730 = -0.0149 for the strained Q1.50 ( ε = +0.50%).

An additional explanation will be given to the value of Δx for the strained Q1.50. The value of Δx = -0.0879 is required for lattice matching with a mask width of Wm = 5 µm. Since an additional deviation of Δx = +0.0730 is required to introduce a compressive strain of +0.5% by modification of the proportion of the group III element, the total variation becomes Δx = -0.0149. A PL peak wavelength of 1496 nm and a PL spectrum half-width of 28 meV were observed for WLD (=9 µm), while a PL peak wavelength of 1556 nm and a PL spectrum half-width of 34 meV were observed for the WMOD (= 5 µm).

Then, as shown in the sectional view of the portion shown in FIG. 16 along line C-C' in FIG. 17, after removing a part of the SiO₂ from both sides of the selectively grown layer (FIG. 17(b)), the p-InP cladding layer 404 (1.5 µm thickness, p = 1 × 10¹⁸ cm⁻³) and the p-InGaAs cap layer 405 (0.25 µm thickness, p = 6 × 10¹⁸ cm⁻³) are grown by the selective MOVPE process as shown in FIG. 17(c). Then the p⁺-InGaAs cap layer 405 measuring 30 µm is removed between the DFB laser region 402a and the EA modulator region 402b thereby establishing electrical isolation, and the p-type electrode 407 is formed with the SiO₂ film 406 used as an inter-layer film as shown in FIG. 18.

The n-type electrode 408 is formed by polishing the back of the n-InP substrate 401 until the thickness becomes 120 µm.

The characteristics of this semiconductor laser were evaluated by applying a high-reflection coating having a reflectance of 95% to the end face of the DFB laser side and an anti-reflection coating having a reflectance below 0.1% to the end face of the modulator side, with the laser made to a total length of 600 µm, or 400 µm of the DFB laser region plus 200 µm of the EA modulator region.

The laser showed an oscillation threshold current of 4.5 mA and a high slope efficiency of 0.30 W/A, and an optical output power of 16 mW was obtained when a current of 60 mA was input into the DFB laser and the bias voltage for the EA modulator was set to 0 V. An extinction ratio (ON/OFF ratio) of as high as -25 dB was obtained when a voltage of -2 V was applied to the EA modulator. This is because a large variation in the absorption coefficient was achieved when the electric field was applied due to good crystalline property. This device was used in an experiment of transmission over 1,000 km at 2.5 Gb/s through a zero-dispersion single-mode fiber of 1.3 µm, with a satisfactory power penalty result below 1.5 dB as evaluated with a coding error ratio of 10⁻¹¹.

The semiconductor laser of this embodiment has the effect of improving the characteristics of the semiconductor optical device formed by the selective MOVPE growth process.

Next, the fourth embodiment of an optical semiconductor device and a method for manufacturing the same according to the present invention, and an optical module and an optical communication apparatus which incorporate the optical semiconductor device will be described below, with reference to the accompanying drawings.

FIG. 19 is a schematic perspective view of the optical module (optical communication module) of this embodiment.

This embodiment is adapted to an optical communication module provided with an electro-absorption (EA) type modulator-integrated distributed feedback (DFB) semiconductor laser of the third embodiment.

The optical communication module of this embodiment comprises an optical semiconductor device 502 having a constitution which corresponds to the electro-absorption (EA) type modulator integrated distributed feedback (DFB) semiconductor laser of the third embodiment, an aspherical lens 503, an optical isolator 504, and an electrical interface 501, while an optical fiber 505 is connected thereto as shown in FIG. 19.

The optical communication module is configured so that the optical output from the optical semiconductor device 502 is sent through the aspherical lens 503 and the optical isolator 504 to the optical fiber 505, while the electrical interface 501 is incorporated for driving the optical semiconductor device 502.

The optical communication module of this embodiment makes it possible to generate high speed optical communication signals very efficiently. This is because the optical semiconductor device of the present invention has a low threshold and high efficiency during operation.

Next, the fifth embodiment of an optical semiconductor device and a method for manufacturing the same according to the present invention, and an optical module and an optical communication apparatus which incorporate the optical semiconductor device will be described below, with reference to the accompanying drawings.

FIG. 20 is a schematic perspective view of an optical communication system of this embodiment.

This embodiment is adapted to a wavelength division multiplexing (WDM) optical communication system provided with the optical communication module 500 of the fourth embodiment.

The optical communication system of this embodiment comprises an optical transmitter 600 and an optical receiver 601 which are connected together via the optical fiber 505 as shown in FIG. 20.

The optical transmitter 600 comprises 64 optical transmission modules 500 having different emission wavelengths, an optical multiplexer 605 which multiplexes light signals from the optical transmission modules 500, and a drive unit 602 which drives the optical transmission modules 500.

The optical receiver 601 comprises 64 optical reception modules 603 which correspond to different wavelengths of the optical transmission modules 500, an optical demultiplexer 606 connected to the optical fiber 505, and an optical reception module drive unit 604 which drives the optical reception modules 603.

In the optical communication system of this embodiment, signal light which is output from the optical transmitter 600 is sent through the optical fiber 505 to the optical receiver 601. Optical signals of 64 different wavelengths which have been input into the optical receiver 601 are sent through the optical demultiplexer 606 and input into the 64 optical reception modules 603 that are controlled by the optical reception module drive unit 604, thereby detecting the signals.

The optical communication module of the present invention makes it possible to easily achieve WDM transmission. This is because the optical semiconductor device employed in the optical transmitter has a low threshold and high optical output power.

While the embodiments described above are the semiconductor laser, the spot size converter integrated semiconductor laser, the EA modulator integrated semiconductor laser, and the module and apparatus which employ these devices, the present invention is not limited to these embodiments and can be applied to any optical semiconductor devices which use a III-V compound semiconductor formed by the selective MOVPE process as the major component. For example, the present invention can be applied to a semiconductor optical modulator, a semiconductor optical detector, a semiconductor optical switch, and a semiconductor optical waveguide, or semiconductor optical devices which integrate these components.

The embodiments described above deal only with such cases as a narrow-width selective MOVPE process which allows it to directly form the semiconductor optical waveguide structure without etching the semiconductor layer. However, the present invention can also be applied to a large-width selective MOVPE process wherein the selective growth region is made several micrometers or wider.

The optical semiconductor device and the method for manufacturing the same according to the present invention, and the optical module or the optical communication apparatus employing the semiconductor optical device are constituted as described above, and are capable of obtaining a high quality semiconductor crystal and improving the device characteristics by taking into consideration the effects of varying the proportion of the group V element (As/P) which has been ignored in the prior art when setting the conditions for growing the crystal, for the case when the InGaAsP layer formed by the selective MOVPE process is the major component.

Having thus described an exemplary embodiment of the invention, it will be apparent that various alterations, modifications, and improvements will readily occur to those skilled in the art. Such alterations, modifications, and improvements, though not expressly described above, are nonetheless intended and implied to be within the spirit and scope of the invention. Accordingly, the foregoing discussion is intended to be illustrative only; the invention is limited and defined only by the following claims and equivalents thereto.

## Claims

1. An optical semiconductor device including a III-V compound semiconductor which is a crystalline substance grown by a selective metal-organic vapor phase epitaxy, wherein
said III-V compound semiconductor is formed under a group V element supplying condition different from that of a non-selective metal-organic vapor phase epitaxy so that said compound semiconductor includes at least two kinds of group V elements with desired proportions.

2. The optical semiconductor device according to claim 1, wherein
said III-V compound semiconductor which is a crystalline substance grown by the selective metal-organic vapor phase epitaxy forms an optical waveguide structure.

3. The optical semiconductor device according to claim 1, wherein
said III-V compound semiconductor which is a crystalline substance grown by the selective metal-organic vapor phase epitaxy forms an active layer of a semiconductor laser.

4. The optical semiconductor device according to claim 1, wherein
said III-V compound semiconductor which is a crystalline substance grown by the selective metal-organic vapor phase epitaxy forms a light absorption layer of a semiconductor optical modulator.

5. The optical semiconductor device according to claim 1, wherein
said III-V compound semiconductor which is a crystalline substance grown by the selective metal-organic vapor phase epitaxy forms a light absorption layer of a semiconductor optical detector.

6. The optical semiconductor device according to claim 1, wherein
said III-V compound semiconductor which is a crystalline substance grown by the selective metal-organic vapor phase epitaxy forms a core layer of a semiconductor optical multiplexer/demultiplexer.

7. The optical semiconductor device according to claim 1, wherein
said III-V compound semiconductor which is a crystalline substance grown by the selective metal-organic vapor phase epitaxy forms a core layer of a semiconductor optical switch.

8. An optical semiconductor device comprising two or more kinds of the optical semiconductor device described in claim 1, wherein said III-V compound semiconductor which is a crystalline substance grown by the selective metal-organic vapor phase epitaxy constitutes the optical semiconductor device.

9. A method for manufacturing an optical semiconductor device including a III-V compound semiconductor which includes at least two kinds of group V elements, comprising the steps of:
growing said III-V compound semiconductor using a selective metal-organic vapor phase epitaxy; and,
controlling the amount of the group V elements supplied to a selective growth region in said selective metal-organic vapor phase epitaxy by correcting conditions of a non-selective metal-organic vapor phase epitaxy regarding the amount of the group V elements supplied so that a desired group V composition is realized in said selective growth region.

10. A method for manufacturing an optical semiconductor device including a III-V compound semiconductor which includes at least two kinds of group III elements and at least two kinds of group V elements, comprising the steps of:
growing said III-V compound semiconductor using a selective metal-organic vapor phase epitaxy; and,
controlling the amount of the group III elements and the group V elements supplied to a selective growth region in said selective metal-organic vapor phase epitaxy by correcting conditions of a non-selective metal-organic vapor phase epitaxy regarding the amount of the group III elements and the group V elements supplied so that a desired group V composition and band gap energy are realized in said selective growth region.

11. The method for manufacturing the optical semiconductor device according to claim 9, wherein
said selective metal-organic vapor phase epitaxy is a narrow width selective metal-organic vapor phase epitaxy which allows direct formation of a semiconductor optical waveguide.

12. The method for manufacturing the optical semiconductor device according to claim 9, wherein
the amount of correction from said non-selective metal organic vapor phase epitaxy condition is determined so that a spectrum peak intensity of photoluminescence which determines a band gap wavelength takes a maximum value while simultaneously changing the amounts of the group III and group V elements being supplied under the condition of keeping the band gap wavelength constant.

13. The method for manufacturing the optical semiconductor device according to claim 9, wherein
the amount of correction from said non-selective metal organic vapor phase epitaxy condition is determined so that the half-width of a spectrum intensity of photoluminescence which determines a band gap wavelength takes a minimum value while simultaneously changing the amounts of the group III and group V elements being supplied under the condition of keeping the band gap wavelength constant.

14. The method for manufacturing the optical semiconductor device according to claim 9, wherein
said III-V compound semiconductor includes at least one of indium, gallium, aluminum, and thallium as the group III element and at least two of phosphorus, arsenic, nitrogen, and antimony as the group V element.

15. The method for manufacturing the optical semiconductor device according to claim 14, wherein said III-V compound semiconductor is specifically InGaAsP type.

16. An optical module, comprising:
the optical semiconductor device of claim 1 or the optical semiconductor device manufactured by the method for manufacturing the optical semiconductor device of claim 9;
a guiding device which guides the optical output from the optical semiconductor device to the outside;
a mechanism for feeding the optical output from the optical semiconductor device to the guiding device; and,
an electrical interface for driving the optical semiconductor device.

17. An optical module, comprising:
the optical semiconductor device of claim 1 or the optical semiconductor device manufactured by the method for manufacturing the optical semiconductor device according to claim 9;
a guiding device which guides the optical input to the optical semiconductor device from the outside;
a mechanism for feeding the optical output from the guiding device to the optical semiconductor device; and,
an electrical interface for driving the optical semiconductor device.

18. An optical communication apparatus, comprising:
an optical transmitter which includes the optical semiconductor device described in claim 1, the optical semiconductor device manufactured by the method for manufacturing the optical semiconductor device of claim 9, or the optical module of claim 16; and,
a receiving device which receives an optical output from the optical transmitter.

19. An optical communication apparatus, comprising:
an optical transmitter which includes the optical semiconductor device of claim 1, the optical semiconductor device manufactured by the method for manufacturing the optical semiconductor device of claim 9, or the optical module of claim 16; and,
a transmission device which transmits an optical input to the optical receiver.
